# EUROPEAN PATENT SPECIFICATION

(11) **EP 3 128 601 B1**
(45) Date of publication and mention of the grant of the patent: **25.03.2020**
(21) Application number: 15773111.8
(22) Date of filing: 23.02.2015
(51) Int. Cl.: H02J 7/00, G01R 31/36

(54) **BACKUP POWER SOURCE SYSTEM AND METHOD THEREOF**
RESERVESTROMQUELLENSYSTEM UND UND VERFAHREN DAFÜR
SYSTÈME SOURCE D'ALIMENTATION DE SECOURS ET PROCÉDÉ ASSOCIÉ

(30) Priority: 31.03.2014 JP 2014073955
(43) Date of publication of application: 08.02.2017
(73) Proprietor: Kabushiki Kaisha Toshiba, Minato-ku Tokyo 105-8001 (JP)
(72) Inventor: UCHIDA Katsuya, Tokyo 105-8001 (JP); HOSHINO Masayuki, Tokyo 105-8001 (JP); OKABE Ryo, Tokyo 105-8001 (JP); KANEKO Norihiro, Tokyo 105-8001 (JP); SATO Makoto, Tokyo 105-8001 (JP)
(74) Representative: AWA Sweden AB
(86) International application number: PCT/JP2015/055046
(87) International publication number: WO 2015/151649

(56) References cited:
- EP-A1- 2 660 615
- WO-A1-2013/069328
- WO-A1-2013/069328
- JP-A- H0 817 477
- JP-A- 2001 091 605
- JP-A- 2009 146 843
- JP-A- 2012 043 623
- JP-A- 2013 141 379
- US-A- 5 406 266

## Description

### BACKGROUND OF THE INVENTION

### [Field of the Invention]

Embodiments of the present invention relate to a backup power supply system, a deterioration estimating device, and a deterioration estimating method.

### [Description of Related Art]

A deterioration state of a secondary battery may be estimated to prevent erroneous operation or stopping of a power system using the secondary battery. When a deterioration state of a secondary battery is estimated, it is necessary to temporarily stop a electric power system including the secondary battery. However, in a certain electric power system, there is a possibility that the system will not be temporarily stopped at an appropriate time to estimate a deterioration state of a secondary battery. The document WO2013/069328 A1 discloses a system for monitoring a condition state of a storage battery, whose degradation is estimated based on values from among current resistance, temperature, voltage and internal resistance of battery.

### [SUMMARY OF THE INVENTION]

### [Issue To Be Solved By The Invention]

Issues of the present invention are to provide a backup power supply system and a deterioration estimating method in which a system can be temporarily stopped at a more appropriate time to estimate a deterioration state of a secondary battery.

### [Means For Solving The Issue]

This problem is solved by a backup power supply system according to claim 1 and a corresponding method according to claim 7.

### [Brief Description Of The Drawings]

Fig. 1 is a diagram illustrating an example of a configuration of a power system according to a first embodiment.
Fig. 2 is a diagram illustrating an example of a configuration of a power system according to a second embodiment.

### [Embodiments For Carrying Out The Invention]

Hereinafter, a backup power supply system and a backup power supply method according to embodiments of the present invention will be described with reference to the accompanying drawings.

### First Embodiment

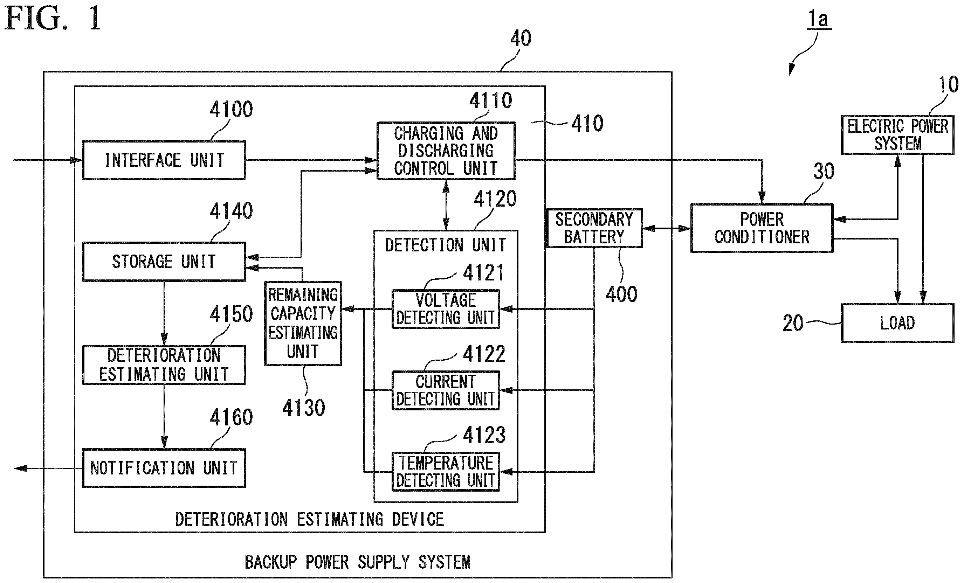

Fig. 1 is a diagram illustrating an example of a configuration of a power system 1a according to a first embodiment. The power system 1a includes a electric power system 10, a load 20, a power conditioner 30, and a backup power supply system 40.

The electric power system 10 supplies power to the load 20. The electric power system 10 supplies power to the power conditioner 30 when the power conditioner 30 operates in a charging mode. On the other hand, the electric power system 10 is supplied with power from the power conditioner 30 when the power conditioner 30 operates in a discharging mode. The electric power system 10 is power supply equipment that supplies power. The electric power system 10 includes, for example, power generating equipment, electrical substation equipment, cables, or secondary batteries of an electric power company.

The load 20 is supplied with power from the electric power system 10. The load 20 is supplied with power from the power conditioner 30 when the power conditioner 30 operates in the discharging mode. The load 20 is a device serving as a load of power. Examples of the load 20 include household appliances.

An operation mode of the power conditioner 30 is controlled by the backup power supply system 40. The operation mode of the power conditioner 30 includes a charging mode, a discharging mode, and a power supply mode. When the power conditioner 30 operates in the charging mode, the power conditioner 30 converts AC power supplied from the electric power system 10 into DC power and supplies the converted DC power to the backup power supply system 40.

When the power conditioner 30 operates in the discharging mode, the power conditioner 30 converts DC power supplied from the backup power supply system 40 into AC power and supplies the converted AC power to the backup power supply system 40. When the power conditioner 30 operates in the power supply mode, the power conditioner 30 converts DC power supplied from the backup power supply system 40 into AC power and supplies the converted AC power to the load 20.

An example of a configuration of the backup power supply system 40 will be described below.

The backup power supply system 40 is a system that supplies power to the load 20 if necessary. The backup power supply system 40 includes a secondary battery 400 and a deterioration estimating device 410.

When the power conditioner 30 operates in the discharging mode, the secondary battery 400 discharges power to the electric power system 10 via the power conditioner 30. On the other hand, when the power conditioner 30 operates in the charging mode, the secondary battery 400 is supplied with power from the power conditioner 30. When the power conditioner 30 operates in the power supply mode, the secondary battery 400 supplies power to the load 20 via the power conditioner 30.

The secondary battery 400 may be an arbitrary type of battery and is not particularly limited to a specific type of battery, as long as it is a rechargeable battery. Examples of the secondary battery 400 include a lithium ion battery and a nickel hydrogen battery. The secondary battery 400 may be a battery pack in which a plurality of secondary batteries are combined.

The deterioration estimating device 410 is a device that estimates a deterioration state of the secondary battery 400. The deterioration estimating device 410 includes an interface unit 4100, a charging and discharging control unit 4110, a detection unit 4120, a remaining capacity estimating unit 4130, a storage unit 4140, a deterioration estimating unit 4150, and a notification unit 4160. The detection unit 4120 includes a voltage detecting unit 4121, a current detecting unit 4122, and a temperature detecting unit 4123.

When the interface unit 4100 is an operation unit, the interface unit 4100 receives an operation of a user. The interface unit 4100 may include, for example, pressable buttons or a touch panel. When the operation of the user is received, the interface unit 4100 transmits a trigger signal based on the operation of the user to the charging and discharging control unit 4110.

When the interface unit 4100 is a communication unit, the interface unit 4100 receives the trigger signal based on the operation of the user from an information terminal or a host device (which will be described later). Examples of the information terminal include a smartphone, a tablet terminal, and a mobile phone terminal. When the trigger signal is received from the information terminal or the host device, the interface unit 4100 transmits the trigger signal to the charging and discharging control unit 4110.

When the trigger signal is received from the interface unit 4100, the charging and discharging control unit 4110 performs control of discharging the secondary battery 400 and then charging the secondary battery 400 by controlling the power conditioner 30 from the discharging mode to the charging mode. When the trigger signal is received from the interface unit 4100, the charging and discharging control unit 4110 may perform control of charging the secondary battery 400 and then discharging the secondary battery 400 by controlling the power conditioner 30 from the charging mode to the discharging mode. The charging and discharging control unit 4110 outputs information indicating a time at which the discharging ends and information indicating a time at which the charging ends to the detection unit 4120.

The charging and discharging control unit 4110 acquires a voltage value of the secondary battery 400 from the voltage detecting unit 4121. The charging and discharging control unit 4110 acquires a current value of the secondary battery 400 from the current detecting unit 4122. The charging and discharging control unit 4110 acquires temperature information of the secondary battery 400 from the temperature detecting unit 4123. The charging and discharging control unit 4110 controls charging and discharging of the secondary battery 400 based on at least one of the voltage value, the current value, and the temperature information of the secondary battery 400. When discharging of the secondary battery 400 is controlled based on the voltage value of the secondary battery 400, the charging and discharging control unit 4110 discharges the secondary battery 400 up to a predetermined first voltage value. When charging of the secondary battery 400 is controlled based on the voltage value of the secondary battery 400, the charging and discharging control unit 4110 charges the secondary battery 400 up to a second voltage value higher than the first voltage value.

The charging and discharging control unit 4110 may control the charging and discharging of the secondary battery 400 based on a state-of-charge (SOC) value (remaining capacity) of the secondary battery 400. When the discharging of the secondary battery 400 is controlled based on the remaining capacity of the secondary battery 400, the charging and discharging control unit 4110 discharges the secondary battery 400 up to a predetermined first remaining capacity. When the charging of the secondary battery 400 is controlled based on the remaining capacity of the secondary battery 400, the charging and discharging control unit 4110 charges the secondary battery 400 up to a second remaining capacity greater than the first remaining capacity. When the secondary battery 400 is a secondary battery causing a memory effect (for example, a nickel hydrogen battery), the charging and discharging control unit 4110 can prevent a decrease in battery capacity of the secondary battery 400 due to the memory effect by sufficiently discharging from the secondary battery 400 and then charging the secondary battery 400.

The voltage detecting unit 4121 detects the voltage of the secondary battery 400 with a predetermined cycle (for example, with a cycle of 1 second) and outputs the detected voltage value of the secondary battery 400 to the charging and discharging control unit 4110. The voltage detecting unit 4121 stores the voltage value of the secondary battery 400, which has been detected with the predetermined cycle, in the storage unit 4140 via the remaining capacity estimating unit 4130.

The current detecting unit 4122 detects the current of the secondary battery 400 with a predetermined cycle and outputs the detected current value of the secondary battery 400 to the charging and discharging control unit 4110. The current detecting unit 4122 stores the current value of the secondary battery 400, which has been detected with the predetermined cycle, in the storage unit 4140 via the remaining capacity estimating unit 4130.

The temperature detecting unit 4123 detects the temperature of the secondary battery 400 with a predetermined cycle and outputs the detected temperature information of the secondary battery 400 to the charging and discharging control unit 4110. The temperature detecting unit 4123 stores the temperature information of the secondary battery 400, which has been detected with the predetermined cycle, in the storage unit 4140 via the remaining capacity estimating unit 4130.

The remaining capacity estimating unit 4130 estimates the remaining capacity of the secondary battery 400 of which discharging has ended based on the voltage of the secondary battery 400 at the time at which the discharging of the secondary battery 400 has ended. The remaining capacity estimating unit 4130 estimates the remaining capacity of the secondary battery 400 of which charging has ended based on the voltage of the secondary battery detected at the time at which the charging of the secondary battery 400 has ended. The remaining capacity estimating unit 4130 stores the estimated remaining capacity information of the secondary battery 400 for each time of measurement in the storage unit 4140.

The storage unit 4140 is, for example, a random access memory (RAM), a read only memory (ROM), a flash memory, a hard disk drive, or a register. That is, the storage unit 4140 may be a nonvolatile memory. The storage unit 4140 stores the voltage value of the secondary battery 400, the current value of the secondary battery 400, and the temperature information of the secondary battery 400. The storage unit 4140 may store a program for causing a processor such as a CPU to operate. The storage unit 4140 stores the remaining capacity information of the secondary battery 400 for each time at which the voltage is measured by the voltage detecting unit 4121.

The deterioration estimating unit 4150 estimates a deterioration state of the secondary battery 400 based on the remaining capacity information of the secondary battery 400. The deterioration estimating unit 4150 estimates, for example, a battery capacity of the secondary battery 400 as a value indicating the deterioration state of the secondary battery 400. When the value of the remaining capacity or the battery capacity indicating the deterioration state of the secondary battery 400 is equal to or less than a predetermined first threshold value, the deterioration estimating unit 4150 has the notification unit 4160 to output an alert. That is, when the deterioration state of the secondary battery 400 indicates a state which is deteriorated more than a predetermined first deterioration state, the deterioration estimating unit 4150 has the notification unit 4160 to output an alert.

The deterioration estimating unit 4150 may estimate an internal resistance value of the secondary battery 400 as the value indicating the deterioration state of the secondary battery 400 based on the voltage value and the current value of the secondary battery 400. When the internal resistance value indicating the deterioration state of the secondary battery 400 is equal to or greater than a predetermined second threshold value, the deterioration estimating unit 4150 has the notification unit 4160 to output an alert.

The deterioration estimating unit 4150 estimates a predicted value of the remaining capacity or the battery capacity in the future as the value indicating the deterioration state of the secondary battery 400, and has the notification unit 4160 to output an alert when the estimated predicted value of the remaining capacity or the battery capacity is equal to or less than a predetermined third threshold value. That is, the deterioration estimating unit 4150 estimates a future deterioration state of the secondary battery 400, and has the notification unit 4160 to output an alert when the estimated future deterioration state indicates a state which is deteriorated more than a predetermined second deterioration state.

The deterioration estimating unit 4150 may estimate a predicted value of the internal resistance value in the future of the secondary battery 400 as a value indicating the future deterioration state of the secondary battery 400 based on the voltage value and the current value of the secondary battery 400. The deterioration estimating unit 4150 estimates the predicted value of the internal resistance value in the future as the value indicating the deterioration state of the secondary battery 400, and has the notification unit 4160 to output an alert when the estimated predicted value of the internal resistance value is equal to or greater than a predetermined fourth threshold value.

The deterioration estimating unit 4150 estimates the predicted value, for example, based on battery characteristic infonnation or a theoretical value acquired by experiment or the like. For example, time information indicating a shipping time of the backup power supply system 40 may be stored in the storage unit 4140, and the deterioration estimating unit 4150 may calculate a deterioration rate based on the elapsed time from the shipping time and the estimation result of the deterioration state whenever estimating the deterioration state and then calculate the predicted value based on the calculated deterioration rate.

The deterioration estimating unit 4150 determines whether the detection unit 4120 can accurately detect the voltage of the secondary battery 400 based on the temperature information of the secondary battery 400. The deterioration estimating unit 4150 determines that the detection unit 4120 cannot accurately detect the voltage of the secondary battery 400 when the temperature of the secondary battery 400 is out of a predetermined temperature range. When the detection unit 4120 cannot accurately detect the voltage of the secondary battery 400, the deterioration estimating unit 4150 has the notification unit 4160 to output an alert.

The notification unit 4160 outputs the deterioration state estimated by the deterioration estimating unit 4150. The notification unit 4160 is, for example, a display device or a communication device. When the notification unit 4160 is a display device, the notification unit 4160 displays an image indicating the deterioration state of the secondary battery 400.

A part or all of the interface unit 4100, the charging and discharging control unit 4110, the detection unit 4120, the deterioration estimating unit 4150, and the notification unit 4160 are software functional units which operated by causing a processor such as a central processing unit (CPU) to execute the program stored in the storage unit 4140. A part or all of the functional units may be hardware functional units such as a large scale integration (LSI) or an application specific integrated circuit (ASIC).

When it is difficult to provide the backup power supply system 40 with the deterioration estimating device 410, the backup power supply system 40 may not include the deterioration estimating unit 4150. The notification unit 4160 may notify the remaining capacity information of the secondary battery 400 estimated by the remaining capacity estimating unit 4130 to an external system. The external system may estimate the deterioration state of the secondary battery 400 based on the remaining capacity information of the secondary battery 400. Accordingly, the backup power supply system 40 can store the remaining capacity information of the secondary battery 400 in the external system.

The operation of the backup power supply system 40 will be described below.

The interface unit 4100 receives an operation of a user. The interface unit 4100 transmits a trigger signal based on the operation of the user to the charging and discharging control unit 4110.

When the trigger signal is received from the interface unit 4100, the charging and discharging control unit 4110 performs control of discharging the secondary battery 400 and then charging the secondary battery 400 by controlling the power conditioner 30 from the discharging mode to the charging mode. For example, the charging and discharging control unit 4110 checks the remaining capacity of the secondary battery 400 and discharges power from the secondary battery 400 to the electric power system 10 via the power conditioner 30, for example, until the remaining capacity is 0 [%], when the remaining capacity is greater than a predetermined threshold value (for example, 10 [%]). The charging and discharging control unit 4110 charges the secondary battery 400 from the electric power system 10 via the power conditioner 30 until the remaining capacity of the secondary battery 400 is 100 [%].

When the trigger signal is received from the interface unit 4100, the charging and discharging control unit 4110 may perform control of charging the secondary battery 400 and then discharging the secondary battery 400 by controlling the power conditioner 30 from the charging mode to the discharging mode. For example, the charging and discharging control unit 4110 checks the remaining capacity of the secondary battery 400 and charges the electric power system 10 via the power conditioner 30, for example, until the remaining capacity is 100 [%], when the remaining capacity is greater than a predetermined threshold value (for example, 90 [%]). The charging and discharging control unit 4110 discharges power from the electric power system 10 via the power conditioner 30 until the remaining capacity of the secondary battery 400 is 0 [%].

The voltage detecting unit 4121 detects the voltage of the secondary battery 400 during charging or discharging with a predetermined cycle and outputs the detected voltage value of the secondary battery 400 to the charging and discharging control unit 4110.

The current detecting unit 4122 detects the current of the secondary battery 400 during charging or discharging with a predetermined cycle and outputs the detected current value of the secondary battery 400 to the charging and discharging control unit 4110.

The temperature detecting unit 4123 detects the temperature of the secondary battery 400 during charging or discharging with a predetermined cycle and outputs the detected temperature information of the secondary battery 400 to the charging and discharging control unit 4110.

The deterioration estimating unit 4150 estimates the deterioration state of the secondary battery 400 based on the remaining capacity information of the secondary battery 400. The deterioration estimating unit 4150 estimates, for example, the battery capacity of the secondary battery 400 as the deterioration state of the secondary battery 400. The deterioration estimating unit 4150 may estimate the internal resistance value of the secondary battery 400 as the deterioration state of the secondary battery 400 based on the voltage value and the current value of the secondary battery 400.

When the value indicating the deterioration state of the secondary battery 400 is equal to or less than a predetermined first threshold value, the deterioration estimating unit 4150 has the notification unit 4160 to output an alert. When the estimated predicted value is equal to or less than a predetermined second threshold value, the deterioration estimating unit 4150 has the notification unit 4160 to output an alert. When the detection unit 4120 cannot accurately detect the voltage, the deterioration estimating unit 4150 has the notification unit 4160 to output an alert.

The notification unit 4160 outputs the deterioration state estimated by the deterioration estimating unit 4150. The notification unit 4160 may output a warning based on control by the deterioration estimating unit 4150.

As described above, the backup power supply system 40 according to the first embodiment includes the secondary battery 400, the interface unit 4100, the charging and discharging control unit 4110, the detection unit 4120, the remaining capacity estimating unit 4130, the deterioration estimating unit 4150, and the notification unit 4160. The interface unit 4100 transmits a trigger signal based on an operation of a user. The charging and discharging control unit 4110 performs control of discharging from the secondary battery 400 and then charging the secondary battery 400 or control of charging the secondary battery 400 and then discharging the secondary battery 400 when the trigger signal is received from the interface unit 4100. The detection unit 4120 detects a voltage of the secondary battery at different timings. The remaining capacity estimating unit 4130 estimates a remaining capacity of the secondary battery 400 based on the voltage of the secondary battery 400. The deterioration estimating unit 4150 estimates a deterioration state of the secondary battery 400 based on the estimated remaining capacity. The notification unit 4160 outputs the estimated deterioration state.

The deterioration estimating device 410 according to the first embodiment includes the interface unit 4100, the charging and discharging control unit 4110, the detection unit 4120, the remaining capacity estimating unit 4130, the deterioration estimating unit 4150, and the notification unit 4160. The interface unit 4100 transmits a trigger signal based on an operation of a user. The charging and discharging control unit 4110 performs control of discharging the secondary battery 400 and then charging the secondary battery 400 or control of charging the secondary battery 400 and then discharging the secondary battery 400 when the trigger signal is received from the interface unit 4100. The detection unit that 4120 detects a voltage of the secondary battery 400 at different timings. The remaining capacity estimating unit 4130 estimates a remaining capacity of the secondary battery 400 based on the voltage of the secondary battery 400. The deterioration estimating unit 4150 estimates a deterioration state of the secondary battery 400 based on the estimated remaining capacity. The notification unit 4160 outputs the estimated deterioration state.

The deterioration estimating method according to the first embodiment is a deterioration estimating method in the deterioration estimating device 410 including transmitting a trigger signal, performing control, detecting a voltage at different timings, estimating a remaining capacity of the secondary battery 400, estimating a deterioration state of the secondary battery 400, and outputting the deterioration state. In the transmitting of a trigger signal, the trigger signal based on an operation of a user is transmitted from the interface unit 4100. In the performing of control, control of discharging a secondary battery 400 and then charging the secondary battery 400 or control of charging the secondary battery 400 and then discharging the secondary battery is performed when the trigger signal is received from the interface unit 4100. In the detecting of a voltage at different timings, the voltage of the secondary battery 400 is detected at different timings. In the estimating of a remaining capacity of the secondary battery 400, the remaining capacity of the secondary battery 400 is estimated based on the voltage of the secondary battery 400. In the estimating a deterioration state of the secondary battery 400, the deterioration state of the secondary battery is estimated based on the estimated remaining capacity. In the outputting of the deterioration state, the estimated deterioration state is output.

A user can manually operate the interface unit 4100. The interface unit 4100 transmits a rigger signal based on the operation of the user to the charging and discharging control unit 4110.

The interface unit 4100 may receive the trigger signal from the outside and transmit the received trigger signal to the charging and discharging control unit 4110.

Accordingly, in the backup power supply system 40, the deterioration estimating device 410, and the deterioration estimating method according to the first embodiment, it is possible to temporarily stop the backup power supply system 40 at a more appropriate time and to estimate the deterioration state of the secondary battery 400. A user of the backup power supply system 40 can select a time at which an influence is small and review a replacement time of the secondary battery 400.

The different times in the first embodiment are a time at which discharging ends and a time at which charging ends.

The deterioration estimating unit 4150 in the first embodiment estimates the battery capacity or the internal resistance value of the secondary battery 400 as the deterioration state of the secondary battery 400.

The charging and discharging control unit 4110 in the first embodiment controls charging and discharging of the secondary battery 400 based on the voltage value or the remaining capacity of the secondary battery 400.

The deterioration estimating unit 4150 in the first embodiment has the notification unit 4160 to output an alert when the deterioration state of the secondary battery 400 indicates a state which is deteriorated more than a predetermined first deterioration state.

The deterioration estimating unit 4150 in the first embodiment estimates a future deterioration state of the secondary battery 400 and has the notification unit 4160 to output an alert when the estimated future deterioration state indicates a state which is deteriorated more than a predetermined second deterioration state.

The deterioration estimating unit 4150 in the first embodiment determines whether the detection unit 4120 can accurately detect the voltage of the secondary battery 400 based on the temperature of the secondary battery 400. When the detection unit 4120 cannot accurately detect the voltage of the secondary battery 400, the deterioration estimating unit 4150 in the first embodiment has the notification unit 4160 to output an alert.

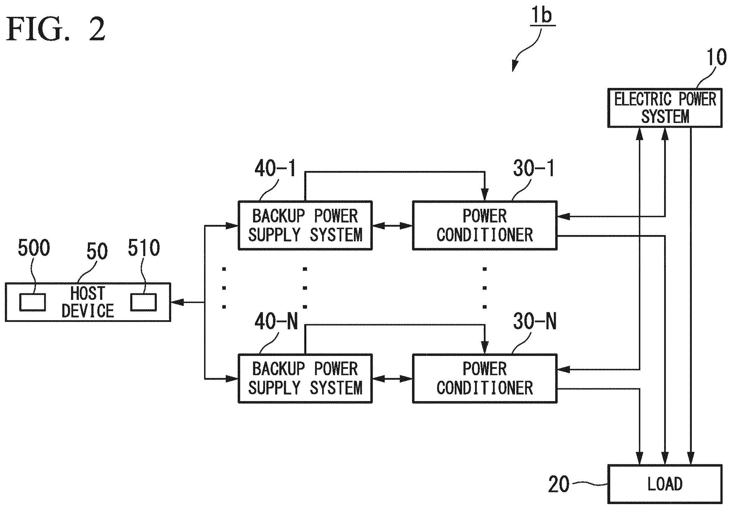

Fig. 2 is a diagram illustrating an example of a configuration of a power system 1b according to the second aspect, the power system 1b includes a electric power system 10, a load 20, power conditioners 30-1 to 30-N (where N is an integer equal to or greater than 2), backup power supply systems 40-1 to 40-N, and a host device 50. In the power system 1b, the plurality of backup power supply systems 40 are connected in parallel. That is, a plurality of secondary batteries 400 are connected in parallel. Hereinafter, details common to the backup power supply systems 40-1 to 40-N will not be referenced by reference signs and will be referred to as "backup power supply systems 40."

The host device 50 includes a host operation units 500 correlated with the backup power supply systems 40. Each host operation unit 500 receives an operation of a user. For example, each host operation unit 500 may include pressable buttons or a touch panel.

The host device 50 includes a host communication unit 510. When an operation of a user is received by one host operation unit 500, the host communication unit 510 transmits a trigger signal to the backup power supply system 40 correlated with the operated host operation unit 500. When the operation of the user is received by one host operation unit 500, the host communication unit 510 transmits remaining capacity information of the secondary batteries 400 of the backup power supply systems 40 not correlated with the operated host operation unit 500 to the backup power supply system 40 correlated with the operated host operation unit 500.

Accordingly, the host communication unit 510 can sequentially switch the backup power supply system 40 serving as a destination of the remaining capacity information and the trigger signal by causing the user to sequentially switch the host operation unit 500 to be operated.

The host communication unit 510 transmits an isolation request signal to the backup power supply systems 40 which are not the destination of the trigger signal. The isolation request signal is a signal for requesting to electrically isolate the secondary battery 400 of the corresponding backup power supply system 40 from the electric power system 10 or the other backup power supply systems 40.

When the backup power supply system 40 correlated with the host operation unit 500 operated by the user completes estimating the deterioration state of the secondary battery 400, the host communication unit 510 transmits a connection request signal to the other backup power supply systems 40. The connection request signal is a signal for requesting to electrically connect the electric power system 10 or the other backup power supply systems 40 to the secondary battery 400 of the corresponding backup power supply system 40.

When a trigger signal based on the operation of the user is received from the host device 50, the interface unit 4100 transmits the trigger signal to the charging and discharging control unit 4110 of the corresponding backup power supply system 40.

When the interface unit 4100 receives the isolation request signal, the charging and discharging control unit 4110 electrically isolates the secondary battery 400 of the corresponding backup power supply system 40 from the electric power system 10. When the interface unit 4100 receives the isolation request signal, the charging and discharging control unit 4110 electrically isolates the secondary battery 400 of the corresponding backup power supply system 40 from the secondary batteries 400 of the other backup power supply systems 40 having received the trigger signal.

Even when the interface unit 4100 receives the isolation request signal, the charging and discharging control unit 4110 does not electrically isolate the secondary battery 400 of the corresponding backup power supply system 40 from the other backup power supply systems 40 not receiving the trigger signal and the load 20. That is, the backup power supply systems 40 of which the deterioration state of the secondary battery 400 is not estimated are kept connected in parallel. The backup power supply systems 40 of which the deterioration state of the secondary battery 400 is not estimated is kept connected to the load 20.

When the trigger signal is received from the interface unit 4100 of the corresponding backup power supply system 40, the charging and discharging control unit 4110 of the backup power supply system 40-n (where n is an integer of 1 to N) performs control of discharging the secondary battery 400 and then charging the secondary battery 400 by controlling the power conditioner 30-n from the discharging mode to the charging mode.

When the remaining capacity of the secondary batteries 400 of the other backup power supply systems 40 is equal to or greater than a predetermined threshold value (for example, 90 [%]), the charging and discharging control unit 4110 may perform control of discharging the secondary battery 400 of the corresponding backup power supply system 40 and then charging the secondary battery 400 by controlling the power conditioner 30 from the discharging mode to the charging mode. Accordingly, the charging and discharging control unit 4110 can equalize the remaining capacity of the secondary battery 400 of the corresponding backup power supply system 40 and the remaining capacity of the secondary batteries 400 of the other backup power supply systems 40 for a short time, after estimation of the deterioration state is completed.

When the trigger signal is received from the interface unit 4100 of the corresponding backup power supply system 40, the charging and discharging control unit 4110 of the backup power supply system 40-n may perform control of charging the secondary battery 400 of the corresponding backup power supply system 40 and then discharging the secondary battery 400 by controlling the power conditioner 30-n from the charging mode to the discharging mode.

When the remaining capacity of the secondary batteries 400 of the other backup power supply systems 40 is equal to or less than a predetermined value (for example, 10 [%]), the charging and discharging control unit 4110 may perform control of charging the secondary battery 400 of the corresponding backup power supply system 40 and then discharging the secondary battery 400 by controlling the power conditioner 30 from the charging mode to the discharging mode. Accordingly, the charging and discharging control unit 4110 can equalize the remaining capacity of the secondary battery 400 of the corresponding backup power supply system 40 and the remaining capacity of the secondary batteries 400 of the other backup power supply systems 40 for a short time, after estimation of the deterioration state is completed.

The charging and discharging control unit 4110 of the backup power supply system 40-n outputs information indicating the time at which the discharge ends and information indicating the time at which the charging ends to the detection unit 4120 of the corresponding backup power supply system 40.

The overall operations of the power system 1b will be described below.

In the host device 50, the host operation unit 500 correlated with the backup power supply system 40-1 receives an operation of a user. The host communication unit 510 of the host device 50 transmits a trigger signal to the backup power supply system 40-1. The host communication unit 510 of the host device 50 transmits an isolation request signal to the backup power supply systems 40-2 to 40-N.

The charging and discharging control unit 4110 of the backup power supply system 40-1 sets up connection of the secondary battery 400 of the backup power supply system 40-1 to the electric power system 10. The charging and discharging control unit 4110 of the backup power supply system 40-1 releases connection of the secondary battery 400 of the backup power supply system 40-1 to the load 20. The charging and discharging control unit 4110 of the backup power supply system 40-1 releases connection of the secondary battery 400 of the backup power supply system 40-1 to the secondary batteries 400 of the backup power supply systems 40-2 to 40-N. Accordingly, the backup power supply systems 40 can prevent a cross flow based on a difference in the remaining capacity between the secondary batteries 400 and thus prevent a bad influence on deterioration estimation.

On the other hand, the charging and discharging control units 4110 of the backup power supply systems 40-2 to 40-N release connection of the secondary batteries 400 of the corresponding backup power supply systems 40 to the electric power system 10. The connection among the secondary batteries of the backup power supply systems 40-2 to 40-N is kept set up. The charging and discharging control units 4110 of the backup power supply systems 40-2 to 40-N set up connection of the secondary batteries 400 of the corresponding backup power supply systems 40 to the load 20. Accordingly, the backup power supply systems 40 can keep use of the load 20 and estimate the deterioration state of the secondary batteries 400.

The backup power supply system 40-1 estimates the deterioration state of the secondary battery 400. The host communication unit 510 of the host device 50 transmits the remaining capacity information of the secondary batteries 400 of the backup power supply systems 40-2 to 40-N to the backup power supply system 40-1. The backup power supply system 40-1 charges or discharges the secondary battery 400 of the backup power supply system 40-1 so as to be equal to the remaining capacity of the secondary batteries 400 of the backup power supply systems 40-2 to 40-N. That is, the backup power supply system 40 charges or discharges the secondary battery 400 of the corresponding backup power supply system 40 so as to have the same remaining capacity as the remaining capacity of the secondary batteries 400 of the other backup power supply systems 40 before the corresponding backup power supply system 40 in which estimation of the deterioration state is completed is electrically connected to the other backup power supply systems 40. Accordingly, the backup power supply system 40 can prevent a cross flow based on the difference in the remaining capacity among the secondary batteries 400 of the other backup power supply systems 40.

The host communication unit 510 of the host device 50 transmits a connection request signal to the backup power supply system 40-1. The backup power supply system 40-1 restores the electrical connection of the secondary battery 400 to the original state. Thereafter, similarly, the backup power supply systems 40-2 to 40-N sequentially estimate the deterioration states of the secondary batteries 400. Information indicating the estimation result may be transmitted from the backup power supply systems 40 to the host device 50.

As described above, the plurality of backup power supply systems 40 according to the second embodiment are connected in parallel to each other. That is, the plurality of secondary batteries 400 are connected in parallel to the electric power system 10 and the load 20.

When the isolation request signal is received by the interface unit 4100, the charging and discharging control unit 4110 electrically isolates the secondary battery 400 of the corresponding backup power supply system 40 from the secondary batteries 400 of the other backup power supply systems 40.

Accordingly, in the backup power supply system 40, the deterioration estimating device 410, and the deterioration estimating method according to the second embodiment, it is possible to prevent occurrence of a cross flow based on a difference in remaining capacity among the secondary batteries 400. In the backup power supply system 40, the deterioration estimating device 410, and the deterioration estimating method according to the second embodiment, it is possible to temporarily stop the backup power supply system 40 at a more accurate time and to estimate the deterioration state of the secondary battery 400. In the backup power supply system 40, the deterioration estimating device 410, and the deterioration estimating method according to the second embodiment, it is possible to further decrease an influence of the backup power supply system 40 on a user and to estimate the deterioration state of the secondary battery 400 while enabling the load 20.

When a trigger signal is received instead of the isolation request signal from the interface unit 4100 and estimation of the deterioration state of the secondary battery 400 of the backup power supply system 40-1 is completed by the deterioration estimating unit 4150, the charging and discharging control unit 4110 of the backup power supply system 40-1 operates as follows. The charging and discharging control unit 4110 of the backup power supply system 40-1 charges or discharges the secondary battery 400 of the backup power supply system 40-1 so as to have the same remaining capacity as the remaining capacity of the secondary batteries 400 of the backup power supply systems 40-2 to 40-N. In this state, the charging and discharging control unit 4110 of the backup power supply system 40-1 electrically connects the secondary battery 400 of the backup power supply system 40-1 to the secondary batteries 400 of the backup power supply systems 40-2 to 40-N. The same is true of the charging and discharging control units 4110 of the backup power supply systems 40-2 to 40_N.

Accordingly, in the backup power supply system 40, the deterioration estimating device 410, and the deterioration estimating method according to the second embodiment, it is possible to prevent occurrence of a cross flow based on a difference in remaining capacity among the secondary batteries 400 of the other backup power supply systems 40.

According to any one of the above-mentioned embodiments, since the interface unit 4100 transmitting a trigger signal based on an operation of a user is provided, it is possible to temporarily stop the backup power supply system 40 at a more accurate time and to estimate the deterioration state of the secondary battery 400.

While preferred embodiments of the invention have been described and illustrated above, it should be understood that these are exemplary of the invention and are not to be considered as limiting. Accordingly, the invention is not to be considered as being limited by the foregoing description, and is only limited by the scope of the appended claims.

## Claims

1. A backup power supply system (40, 40-1,40-N) comprising:
a secondary battery (400);
an interface unit (1400) configured to transmit a trigger signal based on an operation of a user;
a charging and discharging control unit (4110) configured to perform control of discharging the secondary battery (400) and then charging the secondary battery (400) or control of charging the secondary battery (400) and then discharging the secondary battery when the trigger signal is received from the interface unit (4100);
a detection unit (4120) configured to detect a voltage of the secondary battery (400) at different timings;
a remaining capacity estimating unit (4130) configured to estimate a remaining capacity of the secondary battery (400) based on the voltage of the secondary battery (400);
a deterioration estimating unit (4150) configured to estimate a deterioration state of the secondary battery (400) based on the estimated remaining capacity; and
a notification unit (4160) configured to notify the estimated deterioration state,
**characterized in that** the charging and discharging control unit (4110) is configured to electrically isolate the secondary battery (400) of the backup power supply system from a secondary battery of other backup power supply system (40-1,40-N) when the interface unit (4100) received an isolation request signal for requesting electrical isolation, and
wherein the charging and discharging control unit (4110) is configured to charge or discharge the secondary battery (400) of the backup power supply system (40,40-1,40-N) so as to have the same remaining capacity as the remaining capacity of the secondary battery of the other backup power supply system and then to electrically connect the secondary battery (400) of the backup power supply system (40,40-1,40-N) to the secondary battery (400) of the other backup power supply system (40,40-1,40-N) when the trigger signal is received from the interface unit (4100) instead of the isolation request signal and estimation of the deterioration state of the secondary battery (400) of the backup power supply system (40,40-1,40-N) by the deterioration estimating unit (4150) is completed.

2. The backup power supply system (40,40-1,40-N) according to claim 1, wherein the different timings are a time at which discharging ends and a time at which charging ends.

3. The backup power supply system (40,40-1,40-N) according to claim 1, wherein the deterioration estimating unit (4150) is configured to estimate the deterioration state of the secondary battery (400), by further estimating a battery capacity or an internal resistance value of the secondary battery (400).

4. The backup power supply system (40,40-1,40-N) according to claim 1, wherein the charging and discharging control unit (4110) is configured to control charging and discharging of the secondary battery (400) based on the voltage value or the remaining capacity of the secondary battery (400).

5. The backup power supply system (40,40-1,40-N) according to claim 1, wherein the deterioration estimating unit (4150) comprises a notification unit (4160) to output an alert when the deterioration state of the secondary battery (400) is worse than a predetermined first deterioration state.

6. The backup power supply system (40,40-1,40-N) according to claim 1, wherein the deterioration estimating unit (4150) is configured to determine whether the detection unit (4120) accurately detects the voltage of the secondary battery (400) besed on a temperature of the secondary battery (400) and comprises a notification unit (4160) to output when the detection unit (4120) does not accurately detect the voltage of the secondary battery (400).

7. A backup power supply method comprising:
transmitting a trigger signal based on an operation of a user from an interface unit (4100);
performing control of discharging a secondary battery (400) and then charging the secondary battery (400) or control of charging the secondary battery (400) and then discharging the secondary battery (400) when the trigger signal is received from the interface unit (4100);
detecting a voltage of the secondary battery (400) at different timings;
estimating a remaining capacity of the secondary battery (400) based on the voltage of the secondary battery (400);
estimating a deterioration state of the secondary battery (400) based on the estimated remaining capacity;
notifying the estimated deterioration state;
**characterized in that** performing the control comprises:
electrically isolating the secondary battery (400) of the backup power supply system (40,40-1,40-N) from a secondary battery (400) of other backup power supply system (40,40-1,40-N) when receiving an isolation request signal for requesting electrical isolation; and
charging or discharging the secondary battery (400) of a backup power supply system (40,40-1,40-N) which comprises the deterioration estimating device (410) so as to have the same remaining capacity as the remaining capacity of the secondary battery (400) of the other backup power supply system (40,40-1,40-N) and then electrically connecting the secondary battery (400) of the backup power supply system (40,40-1,40-N) to the secondary battery (400) of the other backup power supply system (40,40-1,40-N) when receiving the trigger signal instead of the isolation request signal and estimation of the deterioration state of the secondary battery (400) of the backup power supply system (40,40-1,40-N) is completed.

## Patentansprüche

1. Reservestromversorgungssystem (40, 40-1, 40-N) umfassend:
eine sekundäre Batterie (400);
eine Schnittstelleneinheit (1400), welche dafür ausgelegt ist, basierend auf einer Betätigung durch einen Benutzer ein Auslösesignal zu senden;
eine Ladungs- und Entladungssteuereinheit (4110), welche dafür ausgelegt ist, die Steuerung einer Entladung der sekundären Batterie (400) und danach einer Ladung der sekundären Batterie (400) durchzuführen, oder die Steuerung der Ladung der sekundären Batterie (400) und danach der Entladung der sekundären Batterie durchzuführen, wenn das Auslösesignal von der Schnittstelleneinheit (4100) empfangen wird;
eine Erfassungseinheit (4120), welche dafür ausgelegt ist, eine Spannung der sekundären Batterie (400) zu verschiedenen Zeitpunkten zu erfassen;
eine Einheit zur Berechnung der verbleibenden Kapazität (4130), welche dafür ausgelegt ist, basierend auf der Spannung der sekundären Batterie (400) eine verbleibende Kapazität der sekundären Batterie (400) zu berechnen;
eine Einheit zur Berechnung der Verschlechterung (4150), welche dafür ausgelegt ist, einen Verschlechterungszustand der sekundären Batterie (400) basierend auf der berechneten verbleibenden Kapazität zu berechnen; und
eine Benachrichtigungseinheit (4160), welche dafür ausgelegt ist, den berechneten Verschlechterungszustand anzuzeigen,
**dadurch gekennzeichnet, dass** die Ladungs- und Entladungssteuereinheit (4110) dafür ausgelegt ist, die sekundäre Batterie (400) des Reservestromversorgungssystems von einer sekundären Batterie eines anderen Reservestromversorgungssystems (40-1, 40-N) zu isolieren, wenn die Schnittstelleneinheit (4100) ein Isolierungsanforderungssignal zur Anforderung einer elektrischen Isolierung empfangen hat, und
wobei die Ladungs- und Entladungssteuereinheit (4110) dafür ausgelegt ist, die sekundäre Batterie (400) des Reservestromversorgungssystems (40, 40-1, 40-N) zu laden oder zu entladen, damit diese eine verbleibende Kapazität aufweist, welche der verbleibenden Kapazität der sekundären Batterie des anderen Reservestromversorgungssystems entspricht, und dann die sekundäre Batterie (400) des Reservestromversorgungssystems (40, 40-1, 40-N) elektrisch mit der sekundären Batterie (400) des anderen Reservestromversorgungssystems (40, 40-1, 40-N) zu verbinden, wenn das Auslösesignal statt des Isolierungsanforderungssignal von der Schnittstelleneinheit (4100) empfangen wird und die Berechnung des Verschlechterungszustands der sekundären Batterie (400) des Reservestromversorgungssystems (40, 40-1, 40-N) durch die Einheit zur Berechnung der Verschlechterung (4150) abgeschlossen ist.

2. Reservestromversorgungssystem (40, 40-1, 40-N) nach Anspruch 1, wobei die verschiedenen Zeitpunkte einen Zeitpunkt, an welchem die Entladung endet, und einen Zeitpunkt, an welchem die Ladung endet, sind.

3. Reservestromversorgungssystem (40, 40-1, 40-N) nach Anspruch 1, wobei die Einheit zur Berechnung der Verschlechterung (4150) dafür ausgelegt ist, den Verschlechterungszustand der sekundären Batterie (400) ferner durch Berechnung einer Batteriekapazität oder eines Innenwiderstandswerts der des sekundären Batterie (400) zu berechnen.

4. Reservestromversorgungssystem (40, 40-1, 40-N) nach Anspruch 1, wobei die Ladungs- und Entladungssteuereinheit (4110) dafür ausgelegt ist, die Ladung und Entladung der sekundären Batterie (400) basierend auf dem Spannungswert oder der verbleibenden Kapazität der sekundären Batterie (400) zu steuern.

5. Reservestromversorgungssystem (40, 40-1, 40-N) nach Anspruch 1, wobei die Einheit zur Berechnung der Verschlechterung (4150) eine Benachrichtigungseinheit (4160) zum Ausgeben einer Warnung, wenn der Verschlechterungszustand der sekundären Batterie (400) schlechter ist als ein vorher festgelegter erster Verschlechterungszustand, umfasst.

6. Reservestromversorgungssystem (40, 40-1, 40-N) nach Anspruch 1, wobei die Einheit zur Berechnung der Verschlechterung (4150) dafür ausgelegt ist, basierend auf einer Temperatur der sekundären Batterie (400) zu bestimmen, ob die Erfassungseinheit (4120) die Spannung der sekundären Batterie (400) genau erfasst, und eine Benachrichtigungseinheit (4160), welche anzeigt, wenn die Erfassungseinheit (4120) die Spannung der sekundären Batterie (400) nicht genau erfasst, umfasst.

7. Reservestromversorgungsverfahren umfassend:
Senden eines Auslösesignals basierend auf einer Betätigung eines Benutzers von einer Schnittstelleneinheit (4100) aus;
Durchführen einer Steuerung der Entladung einer sekundären Batterie (400) und danach der Ladung der sekundären Batterie (400), oder einer Steuerung der Ladung der sekundären Batterie (400) und danach der Entladung der sekundären Batterie, wenn das Auslösesignal von der Schnittstelleneinheit (4100) empfangen wird;
Erfassen einer Spannung der sekundären Batterie (400) zu verschiedenen Zeitpunkten;
Berechnen einer verbleibenden Kapazität der sekundären Batterie (400) basierend auf der Spannung der sekundären Batterie (400);
Berechnen eines Verschlechterungszustands der sekundären Batterie (400) basierend auf der berechneten verbleibenden Kapazität;
Anzeigen des berechneten Verschlechterungszustands;
**dadurch gekennzeichnet, dass** das Durchführen der Steuerung umfasst:
das elektrische Isolieren der sekundären Batterie (400) des Reservestromversorgungssystems (40, 40-1, 40-N) von einer sekundären Batterie (400) eines anderen Reservestromversorgungssystems (40, 40-1, 40-N), wenn ein Isolierungsanforderungssignal zum Anfordern einer elektrischen Isolierung empfangen wird; und
Laden oder Entladen der sekundären Batterie (400) eines Reservestromversorgungssystems (40, 40-1, 40-N), welches die Vorrichtung zur Berechnung der Verschlechterung (410) umfasst, damit diese eine verbleibende Kapazität aufweist, welche der verbleibenden Kapazität der sekundären Batterie (400) des anderen Reservestromversorgungssystems (40, 40-1, 40-N) entspricht, und dann elektrisches Verbinden der sekundären Batterie (400) des Reservestromversorgungssystems (40, 40-1, 40-N) mit der sekundären Batterie (400) des anderen Reservestromversorgungssystems (40, 40-1, 40-N), wenn das Auslösesignal statt des Isolierungsanforderungssignals empfangen wird und die Berechnung des Verschlechterungszustands der sekundären Batterie (400) des Reservestromversorgungssystems (40, 40-1, 40-N) abgeschlossen ist.

## Revendications

1. Système d'alimentation électrique de secours (40, 40-1, 40-N) comprenant :
une batterie secondaire (400) ;
une unité d'interface (1400) configurée pour transmettre un signal de déclenchement sur la base d'une opération d'un utilisateur ;
une unité de commande de chargement et de déchargement (4110) configurée pour commander le déchargement de la batterie secondaire (400) puis le chargement de la batterie secondaire (400) ou pour commander le chargement de la batterie secondaire (400) puis le déchargement de la batterie secondaire lorsque le signal de déclenchement est reçu depuis l'unité d'interface (4100) ;
une unité de détection (4120) configurée pour détecter une tension de la batterie secondaire (400) à des moments différents ;
une unité d'estimation de capacité restante (4130) configurée pour estimer une capacité restante de la batterie secondaire (400) sur la base de la tension de la batterie secondaire (400) ;
une unité d'estimation de détérioration (4150) configurée pour estimer un état de détérioration de la batterie secondaire (400) sur la base de la capacité restante estimée ; et
une unité de notification (4160) configurée pour notifier l'état de détérioration estimé,
**caractérisé en ce que** l'unité de commande de chargement et de déchargement (4110) est configurée pour isoler électriquement la batterie secondaire (400) du système d'alimentation électrique de secours par rapport à une batterie secondaire d'un autre système d'alimentation électrique de secours (40-1, 40-N) lorsque l'unité d'interface (4100) a reçu un signal de demande d'isolation pour une demande d'isolation électrique, et
dans lequel l'unité de commande de chargement et de déchargement (4110) est configurée pour charger ou décharger la batterie secondaire (400) du système d'alimentation électrique de secours (40, 40-1, 40-N) de manière à présenter la même capacité restante que la capacité restante de la batterie secondaire de l'autre système d'alimentation électrique de secours, puis pour relier électriquement la batterie secondaire (400) du système d'alimentation électrique de secours (40, 40-1, 40-N) à la batterie secondaire (400) de l'autre système d'alimentation électrique de secours (40, 40-1, 40-N) lorsque le signal de déclenchement est reçu depuis l'unité d'interface (4100) à la place du signal de demande d'isolation et que l'estimation de l'état de détérioration de la batterie secondaire (400) du système d'alimentation électrique de secours (40, 40-1, 40-N) par l'unité d'estimation de détérioration (4150) est terminée.

2. Système d'alimentation électrique de secours (40, 40-1, 40-N) selon la revendication 1, dans lequel les moments différents sont un moment auquel le déchargement se termine et un moment auquel le chargement se termine.

3. Système d'alimentation électrique de secours (40, 40-1, 40-N) selon la revendication 1, dans lequel l'unité d'estimation de détérioration (4150) est configurée pour estimer l'état de détérioration de la batterie secondaire (400), en estimant également une capacité de batterie ou une valeur de résistance interne de la batterie secondaire (400).

4. Système d'alimentation électrique de secours (40, 40-1, 40-N) selon la revendication 1, dans lequel l'unité de commande de chargement et de déchargement (4110) est configurée pour commander le chargement et le déchargement de la batterie secondaire (400) sur la base de la valeur de tension ou la capacité restante de la batterie secondaire (400).

5. Système d'alimentation électrique de secours (40, 40-1, 40-N) selon la revendication 1, dans lequel l'unité d'estimation de détérioration (4150) comprend une unité de notification (4160) pour émettre une alerte lorsque l'état de détérioration de la batterie secondaire (400) est pire qu'un premier état de détérioration prédéterminé.

6. Système d'alimentation électrique de secours (40, 40-1, 40-N) selon la revendication 1, dans lequel l'unité d'estimation de détérioration (4150) est configurée pour déterminer si l'unité de détection (4120) détecte avec exactitude la tension de la batterie secondaire (400) sur la base d'une température de la batterie secondaire (400) et comprend une unité de notification (4160) pour indiquer lorsque l'unité de détection (4120) ne détecte pas avec exactitude la tension de la batterie secondaire (400).

7. Procédé d'alimentation électrique de secours, comprenant :
la transmission d'un signal de déclenchement sur la base d'une opération d'un utilisateur depuis une unité d'interface (4100) ;
la commande du déchargement d'une batterie secondaire (400) puis du chargement de la batterie secondaire (400) ou la commande du chargement de la batterie secondaire (400) puis du déchargement de la batterie secondaire (400) lorsque le signal de déclenchement est reçu depuis l'unité d'interface (4100) ;
la détection d'une tension de la batterie secondaire (400) à des moments différents ;
l'estimation d'une capacité restante de la batterie secondaire (400) sur la base de la tension de la batterie secondaire (400) ;
l'estimation d'un état de détérioration de la batterie secondaire (400) sur la base de la capacité restante estimée ;
la notification de l'état de détérioration estimé ;
**caractérisé en ce que** l'exécution de la commande comprend :
l'isolation électrique de la batterie secondaire (400) du système d'alimentation électrique de secours (40, 40-1, 40-N) par rapport à une batterie secondaire (400) d'un autre système d'alimentation électrique de secours (40, 40-1, 40-N) lors de la réception d'un signal de demande d'isolation pour une demande d'isolation électrique ; et
le chargement ou le déchargement de la batterie secondaire (400) d'un système d'alimentation électrique de secours (40, 40-1, 40-N) comprenant le dispositif d'estimation de détérioration (410) de manière à présenter la même capacité restante que la capacité restante de la batterie secondaire (400) de l'autre système d'alimentation électrique de secours (40, 40-1, 40-N), puis le raccordement électrique de la batterie secondaire (400) du système d'alimentation électrique de secours (40, 40-1, 40-N) à la batterie secondaire (400) de l'autre système d'alimentation électrique de secours (40, 40-1, 40-N) lors de la réception du signal de déclenchement à la place du signal de demande d'isolation et lorsque l'estimation de l'état de détérioration de la batterie secondaire (400) du système d'alimentation électrique de secours (40, 40-1, 40-N) est terminée.
